# EUROPEAN PATENT APPLICATION

(11) **EP 2 051 259 A1**
(43) Date of publication of application: **22.04.2009**
(21) Application number: 08160107.2
(22) Date of filing: 10.07.2008
(51) Int. Cl.: G11C 11/16

(54) **MRAM with resistive property adjustment**

(30) Priority: 15.10.2007 US 872256
(71) Applicant: Honeywell International Inc., Morristown NJ 07960 (US)
(72) Inventor: Katti, Romney R., Shorewood, MN 55331 (US)
(74) Representative: Buckley, Guy Julian

(57) **Abstract**

A magnetic random access memory (MRAM) and a method for reading an MRAM is described. The MRAM may include a magnetoresistive bit, a read architecture coupled to the magnetoresistive bit that forms a read path with the magnetoresistive bit for performing a read operation on the magnetoresistive bit, and a resistive element in the read path that adjusts resistive properties of the magnetoresistive bit during the read operation. Preferably, the resistive element will act in series with the magnetoresistive bit. The resistive element may be a resistive element between the magnetoresistive bit and the read architecture. Alternatively, the resistive element may be a layer of the magnetoresistive bit. Alternatively yet, the resistive element may be an element of the read architecture.

## Description

### GOVERNMENT RIGHTS

The United States Government has acquired certain rights in this invention pursuant to Contract No. N00030-06-C-0003/SC001-0000000064/D50497 awarded by the United States Navy Strategic Systems Program/Trident.

### FIELD

The invention relates to a magnetic random access memory (MRAM), and more particularly to reading MRAMs.

### BACKGROUND

MRAM is a non-volatile memory technology that is gaining popularity in the computer market. Unlike other memory technologies (e.g., SRAM, DRAM, FLASH, etc.) that store data as electric charge or current flows, MRAM stores data as a magnetic state in magnetoresistive storage bits (i.e., MRAM cells). Typically, an MRAM cell includes two ferromagnetic layers (or structures), each of which can hold a magnetic field that has one of two possible polarities. One popular example of an MRAM cell is a magnetic tunnel junction (MTJ), which includes a free magnetic structure for data storage and a pinned magnetic structure for reference, separated by a nonmagnetic insulating barrier layer through which a tunneling current may flow.

Preferably, the possible polarities of the magnetic structures in the MRAM cell will run either parallel or anti-parallel to an easy axis of the MRAM cell. The logic state of the MRAM cell may then depend on the polarity of the magnetic structures. For example, if the magnetic structures have the same polarity, the MRAM cell may be storing a "0." Alternatively, if the magnetic structures have an opposite polarity, the MRAM cell may be storing a "1."

An MRAM may change a polarity of a free magnetic structure of an MRAM cell (i.e. write an MRAM cell) by applying magnetic fields that couple to the free magnetic structure of the MRAM cell. For example, the MRAM may write the MRAM cell using the "toggle writing" method as described in U.S. Pat. No. 6,545,906. The MRAM may generate these magnetic fields via current pulses running through current lines arranged adjacent an MRAM cell. For example, an MRAM may include word lines arranged in one direction and bit lines that are arranged in a second direction that is perpendicular to the first direction. Using this configuration, the MRAM may selectively write data to a single MRAM cell by activating one word line and one bit line, thus generating a composite magnetic field at an MRAM cell located at an intersection of the word line and the bit line.

An MRAM may determine the logic state of an MRAM cell (i.e., read an MRAM cell) by passing a sense current through the MRAM cell and then determining a resistance of the MRAM cell, which indicates the polarity of the magnetic structures. For example, a higher resistance typically indicates that the magnetic structures have an opposite polarity (logic state "1"), whereas a lower resistance typically indicates that the magnetic structures have the same polarity (logic state "0"). The MRAM may pass the sense current through the MRAM cell by turning on an isolation transistor coupled in series with the MRAM cell, and the MRAM may determine the resistance of the MRAM cell using a readout circuit.

Each MRAM cell has various resistive properties that depend on the design (e.g., material, dimensions, layout, etc.) of the MRAM cell. For example, each MRAM cell may have an Rₘᵢₙ value, which is the resistance of the MRAM cell when the free and pinned magnetic structures have the same polarity. As another example, the MRAM cell may have an Rₘₐₓ value, which is the resistance of the MRAM cell when the free and pinned magnetic structures have opposite polarities. As yet another example, the MRAM cell may have a magnetoresistance value, which indicates the relative difference between Rₘᵢₙ and Rₘₐₓ, and is thus typically represented as (Rₘₐₓ - Rₘᵢₙ)/ Rₘᵢₙ. As further example, the MRAM cell may have temperature coefficients, which indicate how resistance values change when temperature changes, and is thus typical represented as ΔR/Δ°C. Other examples of MRAM cell resistive properties may exist as well.

The resistive properties described above may have a large impact on the read process for an MRAM cell. For example, if Rₘᵢₙ and Rₘₐₓ values are small at one or more operating temperatures, the MRAM may have difficulty measuring those values, and thus reading the MRAM cell, accurately. As another example, if the Rₘᵢₙ and Rₘₐₓ values shift over time due to external factors, the MRAM may have difficulty reading the MRAM cell accurately. As yet another example, if the magnetoresistance value is small, the MRAM may have difficulty distinguishing between Rₘᵢₙ and Rₘₐₓ, which may also impact the accuracy of the read process.

Accordingly, an MRAM cell with adjustable resistive properties is desirable.

### SUMMARY

A magnetic random access memory (MRAM) and a method for reading an MRAM is described.

One example of the present invention may take the form of an MRAM that includes (a) a magnetoresistive bit, (b) a read architecture coupled to the magnetoresistive bit, where the magnetoresistive bit and the read architecture form a read path for performing a read operation on the magnetoresistive bit, and (c) a resistive element in the read path that adjusts resistive properties (e.g., resistance, temperature coefficients) of the magnetoresistive bit during the read operation. The resistive element will preferably act in series with the magnetoresistive bit.

The resistive element may be an element coupled between the magnetoresistive bit and the read architecture. In this respect, the resistive element may be a CMOS resistor. Alternatively, the resistive element may be a layer of the magnetoresistive bit (e.g. a magnetic tunnel junction), such as an outer layer or an inner layer of the magnetoresistive bit. In this respect, the resistive element may be a layer of non-magnetic material. Alternatively yet, the resistive element may be an element of the read architecture. In this respect, the resistive element may be a CMOS resistor. Further, in this respect, the resistive element may be coupled between a read line and an isolation transistor, between a readout circuit and a read line, and/or in some other location in the read architecture.

Another example of the present invention may take the form of a method of reading a magnetoresistive bit. The method may involve (a) selecting a magnetoresistive bit for a read operation, (b) providing a resistive element in a read path of the magnetoresistive bit, where the resistive element adjusts resistive properties of the magnetoresistive bit during the read operation, (c) enabling the read operation for the magnetoresistive bit, and (d) measuring a resistance of the magnetoresistive bit. The method may further involve (e) determining a logic state of the magnetoresistive bit based on the resistance of the magnetoresistive bit.

In one example, the function of enabling the read operation for the magnetoresistive bit may include closing the read path of the magnetoresistive bit. In another example, the function of providing a resistive element in a read path of the magnetoresistive bit may include (i) determining resistive properties of the magnetoresistive bit, and (ii) providing the resistive element in the read path based on the determined resistive properties.

Yet another example of the present invention may take the form of a MRAM that includes (a) a magnetic tunnel junction and (b) a read architecture coupled to the magnetic tunnel junction, where the magnetic tunnel junction and the read architecture form a read path for performing a read operation on the magnetic tunnel junction. In this example, the magnetic tunnel junction includes (i) a pinned magnetic structure, (ii) a free magnetic structure, (iii) a spacer layer coupled between the pinned magnetic structure and the free magnetic structure, and (iv) a non-magnetic resistive layer that adjusts resistive properties of the magnetic tunnel junction during the read operation.

These as well as other aspects and advantages will become apparent to those of ordinary skill in the art by reading the following detailed description, with reference where appropriate to the accompanying drawings. Further, it is understood that this summary is merely an example and is not intended to limit the scope of the invention as claimed.

### BRIEF DESCRIPTION OF THE DRAWINGS

Figure 1 is schematic view of a magnetic random access memory (MRAM), according to an example of the present invention;
Figure 2 is a three dimensional view of a first exemplary MRAM, in which the resistive element is a layer of the magnetoresistive bit;
Figure 3 is a three dimensional view of a second exemplary MRAM, in which the resistive element is an element of the read architecture; and
Figure 4 is a flow chart depicting a method of reading a magnetoresistive bit, according to an example of the present invention.

### DETAILED DESCRIPTION

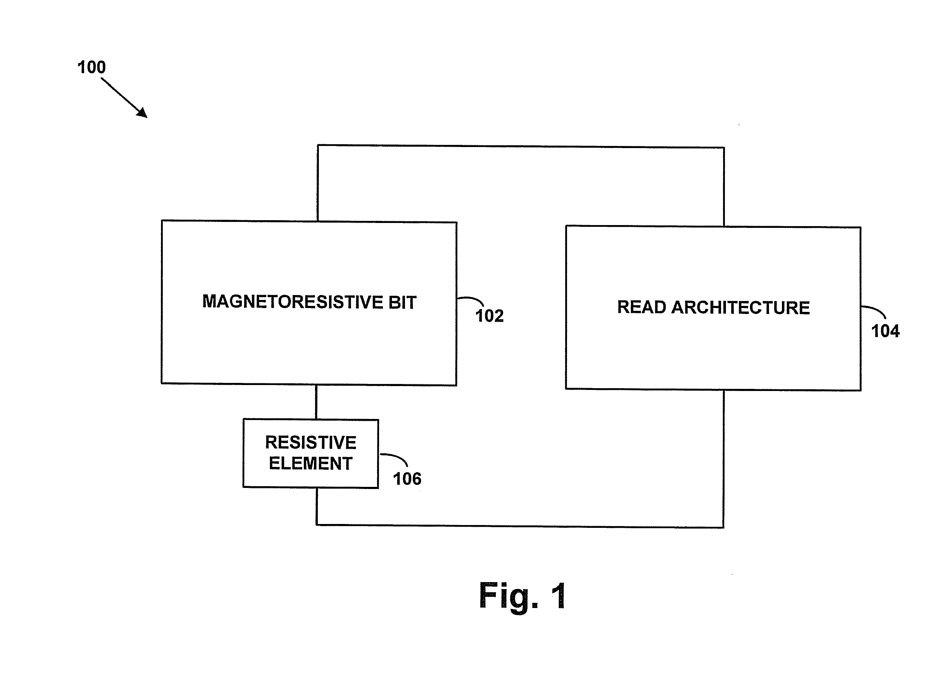

Referring to the drawings, Figure 1 is a schematic view of a magnetic random access memory (MRAM) 100, according to an example of the present invention. As shown, the MRAM 100 may include a magnetoresistive bit 102, a read architecture 104, and a resistive element 106 that adjusts resistive properties of the magnetoresistive bit 102. It should be understood, however, that this and other arrangements described herein are set forth for purposes of example only. As such, the MRAM 100 may additionally include other elements, such as a plurality of magnetoresistive bits 102 arranged into columns and rows. Further, the MRAM 100 may include multiple read architectures 104, or a single read architecture 104 that reads all magnetoresistive bits 102. Further yet, the MRAM 100 may include multiple resistive elements 110, such as one or more resistive elements 106 for each respective magnetoresistive bit 102.

The magnetoresistive bit 102 will preferably be a magnetic tunnel junction (MTJ), although it may alternatively be a spin valve (SV), a pseudo spin valve (PSV), or some other form of magnetic storage element. The magnetoresistive bit 102 may have various resistive properties that depend on a design (e.g., materials, dimensions, layout, etc.) of the magnetoresistive bit 102. The resistive properties may include, among others, Rₘᵢₙ, Rₘₐₓ, magnetoresistance, and/or temperature coefficients for instance. For example, a typical MTJ magnetoresistive bit 102 may have an Rₘᵢₙ of 10 KΩ, an Rₘₐₓ of 15 KΩ, a magnetoresistance of 50%, and negative temperature coefficients. Many other examples are possible as well.

The read architecture 104 may generally function to read a logic state of the magnetoresistive bit 102. As shown, the read architecture 104 may be coupled to a first and second side of the magnetoresistive bit 102 (either directly or via the resistive element 106), thus forming a read path with the magnetoresistive 102 for performing a read operation on the magnetoresistive bit 104. In this respect, when the read path is active, the read architecture 104 may pass a sense current through the magnetoresistive bit 102, sense a voltage across and/or current through the magnetoresistive bit 102, and then determine a resistance of the magnetoresistive bit 102. Based on this resistance, the read architecture 104 may then determine a logic state of the magnetoresistive bit 102.

As discussed above, magnetoresistive bit's resistive properties may have a large impact on the read operation described above. In this respect, depending on an intended application and/or use of the magnetoresistive bit 102, one or more of the magnetoresistive bit's inherent resistive properties may not be desirable. For example, a magnetoresistive bit's resistive properties at certain temperatures, which depend on its temperature coefficients, may not be suitable for aerospace applications. Of course, it may also be desirable to adjust the resistive properties of a magnetoresistive bit for other applications as well.

Accordingly, the resistive element 106 may be added to the read path of the MRAM 100 to adjust resistive properties of the magnetoresistive bit 102 during a read operation. In this respect, the resistive element 106 may be added to the read path of the MRAM 100 in a variety of locations. For example, as shown in Figure 1, the resistive element 106 may be coupled in series between the magnetoresistive bit 102 and the read architecture 104. As another example, the resistive element 106 may be added as a layer of the magnetoresistive bit 102. As yet another example, the resistive element 106 may be added as an element of the read architecture 104. Other examples are possible as well.

The resistive element 106 may take various forms, depending on the desired location and/or resistive properties of the resistive element. For example, the resistive element 106 may be formed from a variety of materials, including magnetic metals, non-magentic metals, and/or insulators. Further, the resistive element 106 may have various dimensions. As one of many examples, the resistive element may be a CMOS resistor (i.e., a resistor formed during a CMOS process), such as a resistor formed from aluminum, copper, diffused silicon, and/or polysilicon.

The resistive element 106 may have its own resistive properties, which depend on the resistive element's design. For example, the resistive element 106 may have at least a Resistance Rᵣₑ and temperature coefficients. As such, with the resistive element 106 in the read path of the MRAM 100, the resistive properties of the resistive element 106 may combine with, and thus adjust, the resistive properties of the magnetoresistive bit 102. In this respect, the resistive element 106 will preferably act in series with the magnetoresistive bit 102, such that the magnetoresistive bit 102 and the resistive element 106 provide a single path for the sense current and the resistance Rᵣₑ sums with the resistance of the magnetoresistive bit 102. For example, if the magnetoresistive bit 102 is at Rₘᵢₙ, the read architecture 104 may measure the resistance as Rₘᵢₙ + Rᵣₑ. As another example, if the magnetoresistive bit 102 is at Rₘₐₓ, the read architecture 104 may measure the resistance as Rₘₐₓ + Rᵣₑ. In either of these examples, the temperature coefficients of the resistive element 106 may also adjust the temperature coefficients of the magnetoresistive bit 102, thus enabling the magnetoresistive bit 102 to operate at different temperature ranges. For example, the temperature coefficients of the resistive element 106 may adjust the temperature coefficients of the magnetoresistive bit 102 such that the magnetoresistive bit 102 can operate in the commercial temperature range (0°C - 100°C) and/or the aerospace temperature range (-55°C - 125°C).

By adjusting the resistances of the magnetoresistive bit 102, and specifically the Rₘᵢₙ value, the resistive element 106 may also adjust the magnetoresistance of the magnetoresistive bit 102. More particularly, the resistive element 106 may decrease the magnetoresistance measured by the read architecture 104. While a decrease in magnetoresistance is not desirable, the magnetoresistance values of current and future magnetoresistive bits 102, such as MTJ_{S}, permit some tradeoff of magnetoresistance for improvement of other resistive parameters.

Advantageously, the MRAM 100 described above with the resistive element 106 in the read path may allow MRAM designers to adjust the inherent resistive properties of magnetoresistive bits. In this respect, the MRAM designers may tailor magnetoresistive bits for different applications without redesigning the entire bit, which may in turn save time and money during the MRAM design process. Further, MRAMs may also selectively use the resistive element to compensate for resistance shifts in magnetoresistive bits.

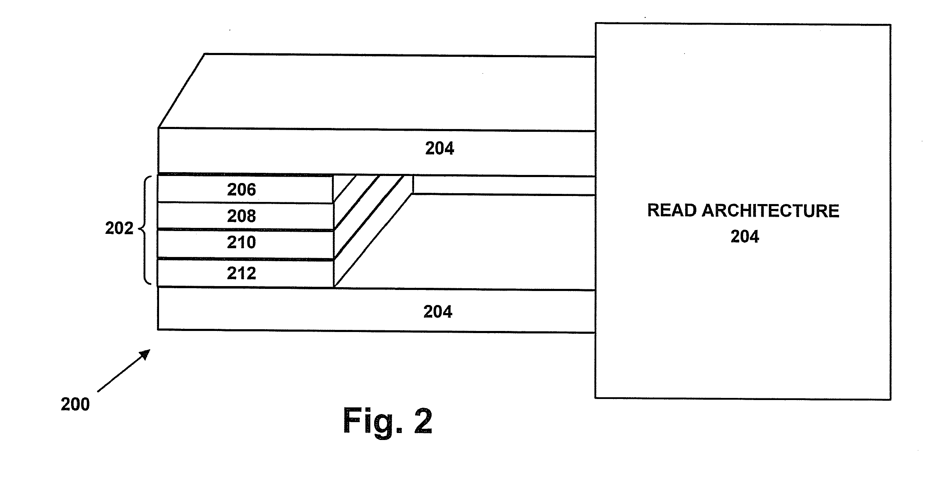

As described above, the resistive element 106 may be added to the read path of the MRAM 100 in a variety of locations, including as an additional layer of the magnetoresistive bit 102. As such, Figure 2 is a three dimensional view of a first exemplary MRAM 200, in which the resistive element is a layer of the magnetoresistive bit 202. The MRAM 200 may include a magnetoresistive bit 202 with a resistive layer 206 and a read architecture 204.

As shown, the magnetoresistive bit 202 may include a pinned magnetic structure 208, a spacer layer 210, and a free magnetic structure 212, along with the resistive layer 206. The spacer layer 210 may be coupled between the pinned magnetic structure 208 and the free magnetic structure 212, such that the pinned magnetic structure 208 is coupled to a first side of the spacer layer 210 and the free magnetic structure 212 is coupled to a second side of the spacer layer 210.

The pinned magnetic structure 208 may include a ferromagnetic structure having a magnetic moment vector and an anti-ferromagnetic structure to fix the magnetic moment vector to a known polarity. As an example, the pinned magnetic structure 208 may include a ferromagnetic layer of Nickel Iron Cobalt (NiFeCo) with a thickness of approximately 2 nm and an anti-ferromagnetic layer of Iron Manganese (FeMn) with a thickness of approximately 5-10 nm. Further, the ferromagnetic and/or anti-ferromagnetic structures of the pinned magnetic structure 208 may be multi-layer structures as opposed to single layer structures. For example, the ferromagnetic structure of the pinned magnetic structure 208 may be a multi-layer synthetic anti-ferromagnet structure (SAF), such as the SAFs described below with reference to the free magnetic structure 212. Other examples are possible as well.

The spacer layer 210 may be a non-magnetic layer that separates the pinned magnetic structure 208 and the free magnetic structure 212. For example, the spacer layer 210 may be an electrically insulating layer that is sufficiently thin to allow tunneling of charge carriers between the pinned magnetic structure 208 and the free magnetic structure 212, thus forming an MTJ between the pinned magnetic structure 208 and the free magnetic structure 212. In this respect, the spacer layer 210 may be a layer of dielectric material such as Aluminum Oxide (AlOₓ) or Magnesium Oxide (MgO), while may provide increased MR. Alternatively, the spacer layer 210 may be an electrically conductive layer that forms an SV. In this respect, the spacer layer 210 may be a layer of copper (Cu). Other examples are possible as well.

The free magnetic structure 212 may include a ferromagnetic structure having a magnetic moment vector that may change polarities in response to an applied magnetic field. In this respect, the free magnetic structure 212 may be a single ferromagnetic layer, such as a layer of Nickel Iron Cobalt (NiFeCo) with a thickness of approximately 2 nm. Alternatively, the free layer structure 106 may be a multi-layer structure, such as an SAF that includes two or more anti-ferromagnetically coupled ferromagnetic layers. For example, the free layer structure 106 may be a tri-layer structure consisting of two layers of NiFeCo with a thickness of 1nm sandwiching a layer of Ru with a thickness of 1nm. Many other examples of free magnetic structures 208 exist as well.

The magnetoresistive bit 202 may have various resistive properties that depend on a design (e.g., materials, dimensions, layout, etc.) of the pinned magnetic structure 208, the spacer layer 210, and/or the free magnetic structure 212. The resistive properties may include, among others, Rₘᵢₙ, Rₘₐₓ, magnetoresistance, and/or temperature coefficients for instance. For example, a typical MTJ magnetoresistive bit 202 may have an Rₘᵢₙ of 10 KΩ, an Rₘₐₓ of 15 KΩ, a magnetoresistance of 50%, and negative temperature coefficients. Many other examples are possible as well.

The resistive layer 206 may take various forms, depending on the desired location and/or resistive properties of the resistive layer 206. For example, the resistive layer 206 may be formed from a variety of materials, including magnetic metals, non-magentic metals, and/or insulators. Further, the resistive layer 206 may have various dimensions, which may in turn control the resistive properties of the resistive layer 206. In one preferred example, the resistive layer 206 may be layer of non-magnetic material, such as FeMn, NiMn, PtMn, FeOx, and/or AlOx, with a thickness ranging from .1 nm to 1000 nm.

The resistive layer 206 may be an outer layer of the magnetoresistive bit 202. For example, as shown, the resistive layer 206 may couple to an outer side of the pinned magnetic structure 208. As another example, the resistive layer 206 may couple to an outer side of the free magnetic structure 212. In either case, as an outer layer of the magnetoresistive bit 202, the resistive layer 206 may further couple to the read architecture 204 of the MRAM cell 200.

Alternatively, although not shown, the resistive layer 206 may be an inner layer of the magnetoresistive bit 102. For example, the resistive layer 206 may be coupled between the pinned magnetic structure 208 and the spacer layer 210. As another example, the resistive layer 206 may be coupled between the spacer layer 210 and the free magnetic structure 212. As yet another example, the resistive layer 206 may be coupled between layers of a multi-layer magnetic structure. Other examples are possible as well.

Regardless of the resistive layer's placement in the magnetic bit 202, the resistive layer 206 and its resistive properties will preferably adjust the resistive properties of the magnetoresistive bit 202 during a read operation. In this respect, the resistive layer 206 will preferably act in series with the other layers of the magnetoresistive bit 202 during the read operation, such that the magnetoresistive bit 202 with the resistive layer 206 provides a single path for a sense current and the resistance of the resistive layer 206 sums with the resistance of the magnetoresistive bit 202. Additionally, the temperature coefficients of the resistive layer 206 may adjust the temperature coefficients of the magnetoresistive bit 202, thus enabling the magnetoresistive bit 202 to operate at different temperature ranges.

The read architecture 204 may generally function to read a logic state of the magnetoresistive bit 202 with the resistive layer 206. As shown, the read architecture 204 may be coupled to a first and second side of the magnetoresistive bit 202 (either directly or via the resistive layer 206), thus forming a read path with the magnetoresistive 202 (and its resistive layer 206). In this respect, when the read path is active, the read architecture 204 may pass a sense current through the magnetoresistive bit 202 with the resistive layer 206, sense a voltage across and/or current through the magnetoresistive bit 202 with the resistive layer 206, and then determine a resistance of the magnetoresistive bit 202 with the resistive layer 206. Based on this resistance, which includes the resistance of the resistive layer 206, the read architecture 204 may then determine a logic state of the magnetoresistive bit 202. Accordingly, the resistive layer 206 of the magnetoresistive bit 202 may impact, and ideally improve, the readability of the magnetoresistive bit 202.

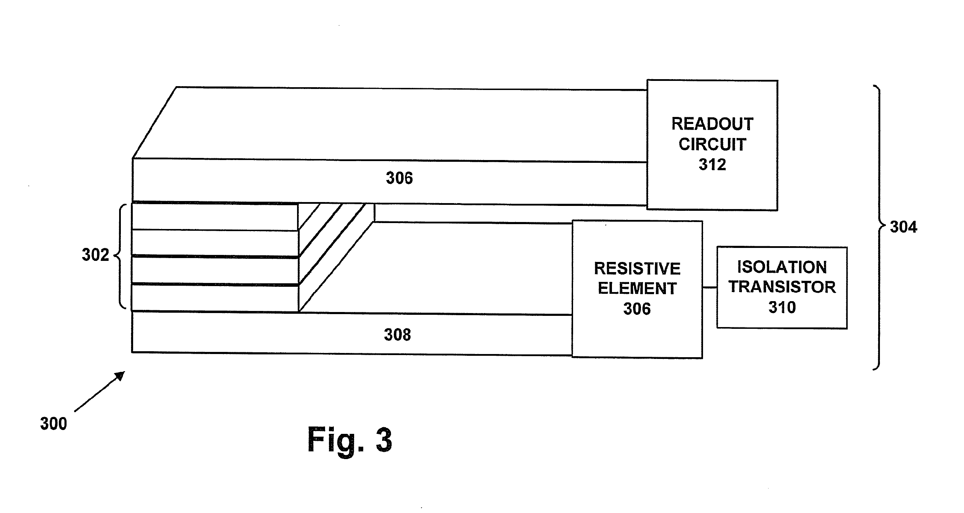

Figure 3 is a three dimensional view of a second exemplary MRAM 300, in which the resistive element is an element of the read architecture. The MRAM 300 may include a magnetoresistive bit 302 and a read architecture 304 with a resistive element 310.

The magnetoresistive bit 302 will preferably be a MTJ, although it may alternatively be an SV, a PSV, or some other form of magnetic storage element. The magnetoresistive bit 302 may have various resistive properties that depend on a design (e.g., materials, dimensions, layout, etc.) of the magnetoresistive bit 302. The resistive properties may include, among others, Rₘᵢₙ, Rₘₐₓ, magnetoresistance, and/or temperature coefficients for instance. For example, a typical MTJ magnetoresistive bit 302 may have an Rₘᵢₙ of 10 KΩ, an Rₘₐₓ of 15 KΩ, a magnetoresistance of 50%, and negative temperature coefficients. Many other examples are possible as well.

The read architecture 304 may generally function to read a logic state of the magnetoresistive bit 302. As shown, the read architecture 304 may include a first read line 306, a second read line 308, an isolation transistor 310, and a readout circuit 312, as well as the resistive element 314. The read architecture 304 may include other elements as well, such as a processor and corresponding data storage (not shown).

The first read line 306 may be a current line coupled to a first outer layer of the magnetic bit 302. The first read line 306 may then apply a sense current to the magnetoresistive bit 302. In this respect, the first read line 306 may be coupled to a current source in the read architecture 304. The second read line 308 may be a current line coupled to a second outer layer of the magnetic bit 302. During a read operation, the second read line 308 may then provide a return path for a sense current passing through the magnetoresistive bit 302 (e.g., to ground).

The isolation transistor 310 may couple to the second read line 308 as shown, or somewhere else along the read path of the MRAM 300. The isolation transistor 310 may then function to enable or disable a read operation on the magnetoresistive bit 302. For example, when the isolation transistor 310 is on (i.e., closed), the read path will be closed and the sense current on the first read line 306 will pass through the magnetoresistive bit 302 to the second read line 308, which then provides the return path for the sense current (e.g., to ground). Alternatively, if the isolation transistor 310 is off (i.e., open), the read path will be open and the sense current will not pass through the magnetoresistive bit 302. The isolation transistor 310 may be any MOSFET transistor that operates as a switch.

The readout circuit 312 may couple to the first read line 310 as shown, or somewhere else along the read path of the MRAM 300. The readout circuit 312 may function to determine a resistance of the magnetoresistive bit 302, such as by sensing a voltage across and/or current through the magnetoresistive bit 302. Based on the resistance, the readout circuit 312 may also determine a logic state of the magnetoresistive bit 312.

The resistive element 314 of the read architecture 304 may take various forms, depending on the desired location and/or resistive properties of the resistive element 314. For example, the resistive element 314 may be formed from a variety of materials, including magnetic metals, non-magentic metals, and/or insulators. Further, the resistive element 314 may have various dimensions. In one preferred example, the resistive element 314 may be a CMOS resistor, such as a resistor formed from aluminum, copper, diffused silicon, and/or polysilicon.

The resistive element 314 may also be added to the read architecture 304 in a variety of locations along the read path. For example, as shown, the resistive element 314 may be coupled between the isolation transistor 310 and the second read line 306. As another example, the resistive element 314 may be coupled between the isolation transistor 310 and ground (not shown). As yet another example, the resistive element 314 may be coupled between the readout circuit 312 and the first read line 306. Depending on the configuration of the read architecture 304, the read architecture 304 may use the same resistive element 314 for multiple magnetoresistive bits 302. Additionally or alternatively, depending on the configuration of the read architecture 304, the read architecture 304 may also selectively add or remove the resistive element 314 in the read path when reading magnetoresistive bits 304. In this respect, the MRAM 300 may use the resistive element 314 when reading particular magnetoresistive elements 302, such as elements that exhibit resistance shift.

Regardless of the resistive element's placement in the read architecture 304, when the resistive element is in the read path, the resistive element 314 and its resistive properties will preferably adjust the resistive properties of the magnetoresistive bit 302. In this respect, the resistive element 314 will preferably act in series with the magnetoresistive bit 302 during the read operation, such that the magnetoresistive bit 302 and the resistive element 314 provide a single path for the sense current and the resistance of the resistive element 314 sums with the resistance of the magnetoresistive bit 302. Additionally, the temperature coefficients of the resistive layer 310 may adjust the temperature coefficients of the magnetoresistive bit 302, thus enabling the magnetoresistive bit 302 to operate at different temperature ranges.

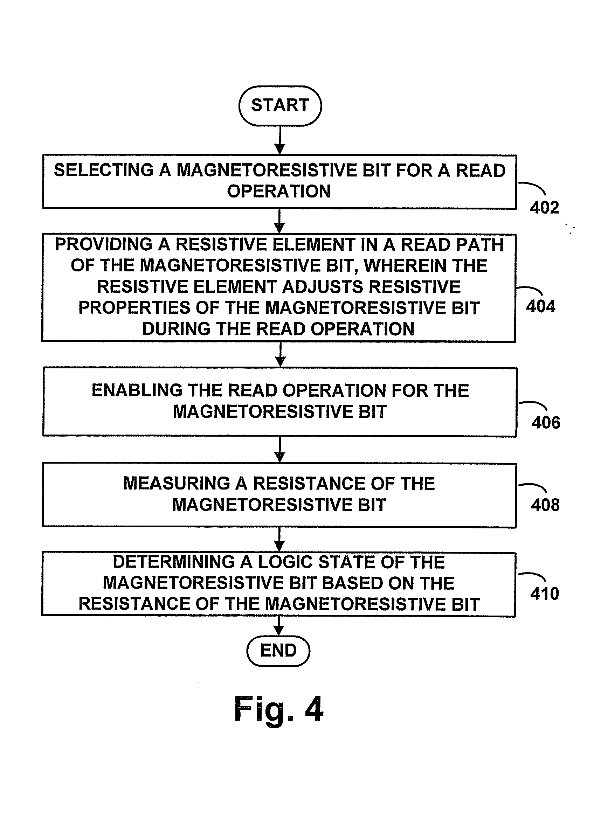

Figure 4 is a flow chart depicting a method of reading a magnetoresistive bit, according to an example of the present invention. At step 402, an MRAM may select a magnetoresistive bit for a read operation. In this respect, the MRAM may determine resistive properties of the magnetoresistive bit and then select the magnetoresistive bit based on the resistive properties. For example, if the resistive properties of the magnetoresistive bit indicate that no compensation is necessary, then the MRAM will not select the magnetoresistive bit. Alternatively, if the resistive properties of the magnetoresistive bit indicate a need for resistive compensation, then the MRAM will select the magnetoresistive bit.

At step 404, the MRAM may provide a resistive element in a read path of the selected magnetoresistive bit, where the resistive element may adjust resistive properties of the magnetoresistive bit during a read operation. At step 406, the MRAM may then enable the read operation for the magnetoresistive bit, such as by closing the read path and allowing a sense current to pass through the magnetoresistive bit. At step 408, while the sense current is passing through the magnetoresistive bit, the MRAM may measure a resistance of the magnetoresistive bit. At step 410, based on this resistance, the MRAM may then determine a logic state of the magnetoresistive bit.

It should be understood that the illustrated embodiments are examples only and should not be taken as limiting the scope of the present invention. The claims should not be read as limited to the described order or elements unless stated to that effect. Therefore, all embodiments that come within the scope and spirit of the following claims and equivalents thereto are claimed as the invention.

## Claims

1. A magnetic random access memory (MRAM) comprising:
a magnetoresistive bit;
a read architecture coupled to the magnetoresistive bit, wherein the magnetoresistive bit and the read architecture form a read path for performing a read operation on the magnetoresistive bit; and
a resistive element in the read path, wherein the resistive element adjusts resistive properties of the magnetoresistive bit during the read operation.

2. The MRAM of cell 1, wherein the resistive element acts in series with the magnetoresistive bit.

3. The MRAM of claim 1, wherein the resistive element is coupled between the magnetoresistive bit and the read architecture.

4. The MRAM of claim 1, wherein the resistive properties of the magnetoresistive bit comprise resistance and temperature coefficients.

5. The MRAM of claim 1, wherein the resistive element comprises a layer of the magnetoresistive bit.

6. The MRAM of claim 5, wherein the resistive element comprises a layer of non-magnetic material.

7. The MRAM of claim 1, wherein the resistive element comprises an element of the read architecture.

8. The MRAM of claim 7, wherein the read architecture comprises:
a first read line coupled to a first side of the magnetoresistive bit;
a second read line coupled to a second side of the magnetoresistive bit;
an isolation transistor coupled to the second read line; and
a readout circuit coupled to the first read line.

9. The MRAM of claim 8, wherein the resistive element is coupled between the second read line and the isolation transistor.

10. The MRAM of claim 8, wherein the resistive element is coupled between the readout circuit and the first read line.
